# DEMANDE DE BREVET EUROPEEN

(11) **EP 1 225 671 A1**
(43) Date de publication de la demande: **24.07.2002**
(21) Numéro de dépôt: 02368007.7
(22) Date de dépôt: 21.01.2002
(51) Int. Cl.: H02G 1/00, G01R 19/155

(54) **Dispositif de vérification de la bonne installation d'un connecteur électrique relié au secteur**

(30) Priorité: 19.01.2001 FR 0100705
(71) Demandeur: Juric, Eddy, 06600 Antibes (FR)
(72) Inventeur: Juric, Eddy, 06600 Antibes (FR)
(74) Mandataire: Bonneau, Gérard

(57) **Abrégé**

Dispositif de vérification de la bonne installation d'un connecteur électrique relié au secteur, comprenant deux fiches mâles (4 et 6) adaptées pour être enfichées dans les deux fiches femelles dudit connecteur (20) et un niveau à bulle (12) pour vérifier l'horizontalité du dispositif (2) installé ;
ledit dispositif étant caractérisé en ce qu'il comprend au moins un voyant lumineux (14) alimenté par le secteur (50) lorsque lesdites fiches mâles ont été enfoncées dans les fiches femelles dudit connecteur et destiné à vérifier que la connexion dudit connecteur au secteur (50) est correcte.

## Description

La présente invention concerne le domaine des dispositifs destinés à vérifier l'installation d'un connecteur électrique et en particulier un dispositif de vérification de la bonne installation d'un connecteur électrique.

Lors de l'installation d'un connecteur électrique, tel qu'une prise murale, deux types de vérification sont nécessaires, à savoir vérifier la connexion du connecteur au secteur, et vérifier l'horizontalité du connecteur lors de sa fixation.

Dans un premier temps l'électricien va mettre en place la boite du connecteur à l'intérieur du support vertical. Puis, il raccorde les fils électriques au connecteur. Ensuite, il fixe le connecteur à la boîte et serre les vis de fixation. Les connecteurs classiques peuvent bouger légèrement de sorte que le niveau peut être ajusté après ce serrage préalable. Une fois l'horizontalité du connecteur réglée, les vis de fixation sont serrées définitivement. La tension est ensuite contrôlée aux bornes du connecteur pour vérifier que le raccordement des fils est correct.

La méthode classique d'installation consiste à ajuster le niveau, soit à vue d'oeil, soit au moyen d'un niveau à bulle classique, c'est à dire un réglet comprenant en son milieu un tube en verre transparent, rempli partiellement d'un liquide de façon à laisser une bulle servant à indiquer le niveau. Si la deuxième solution est plus précise que la première, elle n'en est pas moins peu pratique. En effet, il faut dans ce cas, de la même main maintenir le niveau contre le connecteur, ajuster la position de ce connecteur et serrer le connecteur pour éviter qu'il ne bouge lors du serrage définitif des vis de fixation du connecteur, et de l'autre main serrer les vis de fixation, par exemple avec un tournevis. De plus, sur un chantier ou dans une caisse à outil, la propreté d'un réglet de mise à niveau est rarement impeccable. Il s'ensuit que l'on prend toujours le risque de salir le support vertical sur lequel on installe le connecteur.

Une solution à ce problème a été apportée par le brevet US-6003234. Elle consiste en un dispositif comportant des fiches mâles destinées à être enfichées à l'intérieur des fiches femelles du connecteur secteur aux normes américaines N.E.M.A. 110 volts. Sur la face opposée à celle comprenant les fiches, est disposé un niveau à bulle permettant de contrôlé le niveau du dispositif de sorte que, lorsque le dispositif est fixé dans le connecteur, la bulle soit au centre lorsque le connecteur est de niveau. Il n'est donc plus nécessaire de tenir un dispositif de contrôle du niveau, celui-ci étant immobilisé par les fiches mâles du dispositif. Ainsi, la main tenant le connecteur ne sert qu'au maintien et à l'ajustage du connecteur. De plus, aucun dispositif n'est en contact contre le mur. Enfin, les fiches femelles sont obturées permettant ainsi le travail sous tension sans risque.

Il subsiste néanmoins un inconvénient lors du contrôle de la connexion. On est en effet dans ce cas obligé d'ôter le dispositif pour libérer les prises femelles du dispositif, puis contrôler le courant avec un multimètre ou un testeur à voyant lumineux. Si le raccordement des fils est mauvais, il faut desserrer les vis de fixation du connecteur, raccorder à nouveau les fils, serrer à nouveau les vis de fixation du connecteur et fixer le dispositif de vérification sur le connecteur pour ajuster le niveau.

C'est pourquoi le but de la présente invention est de fournir un dispositif permettant de contrôler facilement l'horizontalité du connecteur tout en contrôlant la connexion du connecteur au secteur.

Plus précisément l'objet de l'invention est un Dispositif de vérification de la bonne installation d'un connecteur électrique relié au secteur, comprenant deux fiches mâles adaptées pour être enfichées dans les deux fiches femelles dudit connecteur et un niveau à bulle pour vérifier l'horizontalité du dispositif installé ;
ledit dispositif étant caractérisé en ce qu'il comprend au moins un voyant lumineux alimenté par le secteur lorsque lesdites fiches mâles ont été enfoncées dans les fiches femelles dudit connecteur et destiné à vérifier que la connexion dudit connecteur au secteur est correcte.

Les buts, objets et caractéristiques de l'invention apparaîtront plus clairement à la lecture de la description qui suit faite en référence aux dessins dans lesquels :
la figure 1 représente une vue en perspective cavalière du dispositif de vérification selon la présente invention,
la figure 2 représente le dispositif de vérification enfiché dans un connecteur fixé dans un support vertical,
la figure 3 représente le schéma électrique du dispositif de vérification selon un mode particulier de réalisation,
les figures 4A et 4B représentent respectivement la lentille du contacteur à liquide en position horizontale et la même lentille en position inclinée.

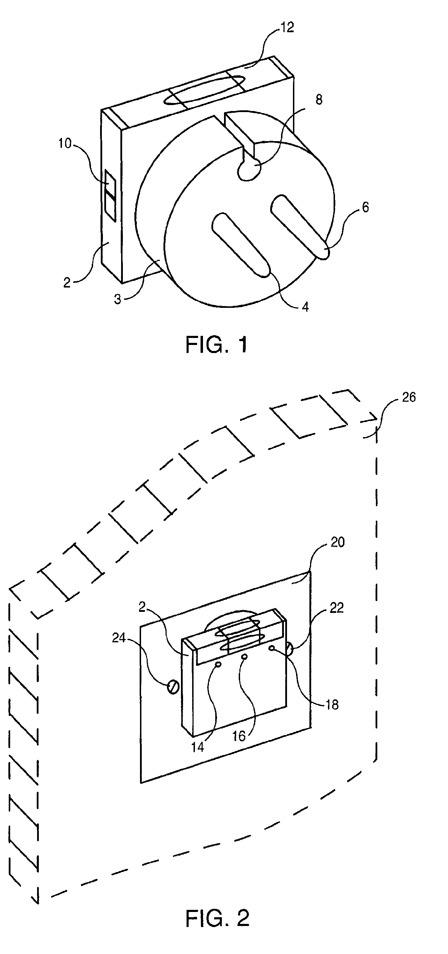

En référence à la figure 1, le dispositif selon l'invention comprend un boîtier 2 dont une partie 3 est cylindrique comme une prise mâle classique et comporte deux fiches mâles 4 et 6 pour la connexion électrique et une fiche femelle 8 pour la terre. Le boîtier 2 comporte un interrupteur 10 dont on verra l'utilité par la suite et un niveau à bulle 12 pour vérifier l'horizontalité du dispositif une fois installé. A noter que le dispositif peut également comporter un autre niveau à bulle, placé orthogonalement au premier, pour vérifier l'horizontalité dans le cas ou le connecteur doit être installé en position verticale, c'est à dire avec ses deux fiches femelles alignées perpendiculairement à l'horizontale

Lorsque les fiches mâles du dispositif selon l'invention ont été enfoncées dans les fiches femelles du connecteur, le dispositif se présente de la manière illustrée sur la figure 2.

Le boîtier 2 est en contact avec le connecteur 20 qui a été intégré dans un mur 26 et fixé grâce aux deux vis de fixation 22 et 24. Hormis le niveau à bulle 12, le boîtier comporte trois voyants 14, 16 et 18 dans un mode de réalisation préférentiel. Le voyant 14 sert à vérifier la bonne connexion électrique du connecteur au secteur, le voyant 16 sert à vérifier la bonne connexion du connecteur à la terre et le voyant 18 sert à vérifier l'horizontalité du connecteur.

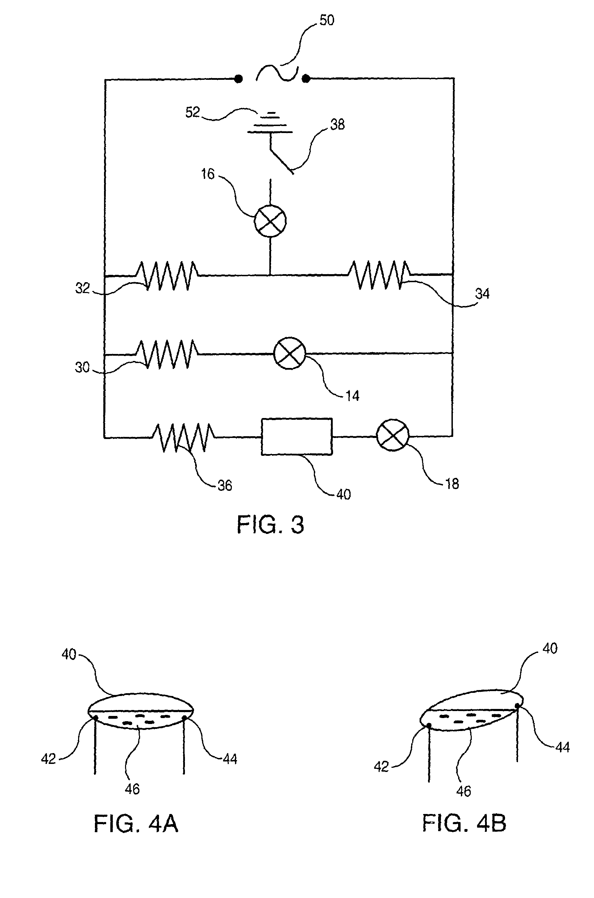

Le circuit électrique contenu dans le boîtier 2 est représenté sur la figure 3. Le voyant 14 de vérification de la connexion électrique est alimenté par le secteur 50 lorsque le dispositif est enfiché au travers et d'une résistance 30. En cas de mauvaise connexion du connecteur 20 au secteur 50, le voyant n'est pas alimenté et n'est donc pas lumineux.

Le voyant 16 est connecté à la terre 52 grâce à la fiche femelle 8 du dispositif, illustrée sur la figure 1. Il est alimenté par le secteur 50 à travers l'une des résistances 32 et 34 de valeur égale, et après qu'un interrupteur 38 a été fermé. En cas de bonne connexion du connecteur à la terre, le voyant 16 est alimenté par le secteur 50 soit à travers la résistance 32, soit à travers la résistance 34 selon que c'est l'une ou l'autre des fiches mâles du dispositif qui est connectée à la phase (ou au neutre) à travers la fiche femelle correspondante du connecteur. A Noter que l'interrupteur 38 n'est pas indispensable mais est utile pour éviter une fuite du courant vers la terre.

Enfin, le voyant 18 est alimenté par le secteur 50 par l'intermédiaire d'une résistance 36 et d'un contacteur à liquide 40 qui ne laisse passer le courant que si l'horizontalité du dispositif est correcte. A supposer que la connexion électrique du connecteur soit correcte, le voyant 18 ne s'allume que si la liaison est établie à travers le contacteur à liquide 40 c'est à dire que si le connecteur 20 est bien horizontal.

A noter que les voyants lumineux 14, 16 et 18 peuvent avoir les mêmes caractéristiques mais être de couleur différente. De manière à alimenter chacun des voyants par un courant de même valeur, les résistances 30, 32, 34 et 36 ont de préférence la même valeur qui peut être de plusieurs milliers d'ohms.

Le contacteur à liquide 40 est illustré sur les figures 4A et 4B. C'est une lentille remplie à moitié d'un liquide conducteur 46. Lorsque le dispositif est de niveau, c'est à dire lorsque le connecteur est bien horizontal, le contacteur se présente de la manière illustrée sur la figure 4A. Dans ce cas, les deux bornes métalliques 42 et 44 reliant le circuit d'alimentation du voyant 18 au secteur 50 se trouvent dans le liquide 46 (en fait à la limite du liquide) et la connexion électrique peut se faire. Si, par contre, l'horizontalité du contacteur n'est pas réalisée, le contacteur se présente de la manière illustrée sur la figure 4B, c'est à dire que l'une des bornes, en l'occurrence la borne 44, ne se trouve plus dans le liquide conducteur. Dans ce cas, la liaison électrique entre le voyant 18 et le secteur 50 n'est pas réalisée et le voyant 18 ne s'allume pas.

Selon un autre mode de réalisation, le voyant 18 et le contacteur à liquide 40 peuvent ne pas être connectés au secteur mais à une pile incluse dans le boîtier du dispositif. Dans ce cas, le voyant lumineux permet, lorsqu'il est allumé, de vérifier l'horizontalité du connecteur même si ce dernier n'est pas connecté correctement au secteur.

## Revendications

1. Dispositif de vérification de la bonne installation d'un connecteur électrique relié au secteur, comprenant deux fiches mâles (4 et 6) adaptées pour être enfichées dans les deux fiches femelles dudit connecteur (20) et un niveau à bulle (12) pour vérifier l'horizontalité du dispositif (2) installé ;
ledit dispositif étant **caractérisé en ce qu'**il comprend au moins un voyant lumineux (14) alimenté par le secteur (50) lorsque lesdites fiches mâles ont été enfoncées dans les fiches femelles dudit connecteur et destiné à vérifier que la connexion dudit connecteur au secteur (50) est correcte.

2. Dispositif de vérification selon la revendication 1, **caractérisé en ce qu'**il comprend en outre une fiche femelle (8) adaptée pour y enficher la fiche mâle du connecteur qui est reliée à la terre (52) et **en ce qu'**il comprend un deuxième voyant lumineux (16) alimenté par le secteur lorsque les fiches mâles (4 et 6) dudit dispositif de vérification ont été enfoncées dans les fiches femelles dudit connecteur et lorsque la fiche mâle de terre dudit connecteur est enfichée dans la fiche femelle dudit dispositif de vérification, ledit deuxième voyant lumineux étant destiné à vérifier que la connexion dudit connecteur à la terre est correcte.

3. Dispositif de vérification selon la revendication 2, **caractérisé en ce qu'**il comprend un interrupteur (38) disposé entre ledit deuxième voyant lumineux (16) et la fiche femelle (8) dudit dispositif de vérification.

4. Dispositif de vérification selon l'une quelconque des revendications précédentes, **caractérisé en ce que** il comprend en outre une lentille (40) remplie partiellement d'un liquide conducteur (46) et disposant en ses extrémités de deux bornes électriques (42 et 44) situées de part et d'autre de ladite lentille, de sorte que ledit liquide n'est simultanément en contact avec les deux bornes que si ledit dispositif de vérification est horizontal, lesdites bornes étant montées en série avec un voyant lumineux de sorte que ce voyant lumineux sert de vérificateur de niveau d'horizontalité.

5. Dispositif de vérification selon la revendication 4, **caractérisé en ce que** ledit voyant lumineux est un troisième voyant lumineux (18).

6. Dispositif de vérification selon la revendication 5, **caractérisé en ce que** le troisième voyant lumineux (18) est disposé sous le verre dudit niveau à bulle (12) de sorte que ledit troisième voyant lumineux peut diffuser sa lumière à travers le liquide dudit niveau à bulle.

7. Dispositif de vérification selon la revendication 5 ou 6, **caractérisé en ce que** la dite lentille (40) et ledit troisième voyant lumineux (18) sont également alimentés par une batterie pour permettre la vérification du niveau hors tension.

8. Dispositif de vérification selon l'une quelconque des revendications précédentes, **caractérisé en ce qu'**il possède une largeur voisine de celle de l'emplacement du connecteur comprenant les fiches de connexion, de sorte que, lorsque ledit dispositif de vérification (2) est fixé sur le connecteur (20), les vis de fixation (22 et 24) du connecteur au support vertical (26) restent accessibles.

9. Dispositif de vérification selon l'une quelconque des revendications précédentes, **caractérisé en ce qu'**il comprend en outre un niveau à bulle destiné à vérifier la verticalité du dispositif installé.
